(19) Europäisches Patentamt
European Patent Office
Office européen des brevets

(11) Veröffentlichungsnummer: **0 244 763 B1**

(12) **EUROPÄISCHE PATENTSCHRIFT**

(45) Veröffentlichungstag der Patentschrift: **10.03.93**

(51) Int. Cl.⁵: **G03F 7/022**

(21) Anmeldenummer: **87106283.2**

(22) Anmeldetag: **30.04.87**

# (54) Positiv-arbeitendes lichtempfindliches Gemisch und daraus hergestelltes lichtempfindliches Aufzeichnungsmaterial.

(30) Priorität: **02.05.86 US 858616**

(43) Veröffentlichungstag der Anmeldung:
**11.11.87 Patentblatt 87/46**

(45) Bekanntmachung des Hinweises auf die Patenterteilung:
**10.03.93 Patentblatt 93/10**

(84) Benannte Vertragsstaaten:
**DE FR GB IT NL**

(56) Entgegenhaltungen:
**DE-C- 879 203**
**JP-A-60 133 446**

**PATENT ABSTRACTS OF JAPAN, Band 9, Nr. 296 (P-407)[2019], 22. November 1985; & JP-A-60 133 446 (FUJI SHASHIN FILM K.K.) 16-07-1985**

(73) Patentinhaber: **HOECHST CELANESE CORPORATION**
**Route 202-206 North**
**Somerville, N.J. 08876(US)**

(72) Erfinder: **Potvin, Robert E.**
**100 Pawtuxet Terrace Apt. 6**
**West Warwick Rhode Island 02893(US)**
Erfinder: **St. Alban, Jonas O.**
**P.O. Box 43**
**Coventry Rhode Island 02816(US)**
Erfinder: **Sobodacha, Chester J.**
**R.R. 7, Box 2857 18 Daniel Drive**
**Coventry Rhode Island 02816(US)**

(74) Vertreter: **Neubauer, Hans-Joachim, Dr. et al**
**KALLE Niederlassung der Hoechst AG Patentabteilung Postfach 3540 Rheingaustrasse 190**
**W-6200 Wiesbaden1 (DE)**



Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung betrifft ein positiv-arbeitendes lichtempfindliches Gemisch, insbesondere ein Photoresistgemisch, im wesentlichen bestehend aus einem Bindemittel und einer lichtempfindlichen Verbindung.

Die Herstellung von positiv-arbeitenden Photoresistgemischen ist bekannt (US-A-3,666,473, US-A-4,115,128, US-A-4,173,470 und US-A-4,550,069). Dabei handelt es sich im wesentlichen um Kombinationen eines alkalilöslichen Novolakharzes bzw. eines Polyvinylphenols mit einer lichtempfindlichen Verbindung, gewöhnlich einer substituierten o-Chinondiazidverbindung. Die Harze und lichtempfindlichen Substanzen sind in einem organischen Lösemittel oder Lösemittelgemisch gelöst und werden als dünne Schicht bzw. Beschichtung auf einen geeigneten Schichtträger aufgebracht.

Die Novolak- bzw. Polyvinylphenolkomponenten dieser Photoresistgemische sind zwar in wäßrig-alkalischen Lösungen löslich, die lichtempfindlichen o-Chinondiazidverbindungen wirken allerdings als Auflösungsverzögerer auf das Harz. Wenn jedoch bestimmte Bereiche des beschichteten Trägers mit aktinischer Strahlung belichtet werden, erfährt die lichtempfindliche Verbindung eine durch die Bestrahlung induzierte strukturelle Umwandlung, und die belichteten Bereiche der Beschichtung werden löslicher als die unbelichteten. Aufgrund dieses Löslichkeitsunterschiedes lösen sich die belichteten Bereiche der Photoresistschicht in einer alkalischen Entwicklerlösung, so daß auf dem Träger ein positives Reliefbild entsteht.

In den meisten Fällen wird der belichtete und entwickelte Träger mit einer Ätzlösung behandelt, wobei die Photoresistschicht die nicht belichteten Bereiche des Trägers vor dem Ätzmittel schützt.

Das nach dem oben beschriebenen Verfahren auf dem Träger erzeugte Reliefbild eignet sich für verschiedene Anwendungszwecke, zum Beispiel als Maske oder Bild, beispielsweise bei der Herstellung von Halbleiterbauelementen in der Mikroelektronik.

Wichtige Eigenschaften für die kommerzielle Nutzung eines Photoresists sind die folgenden: Lichtempfindlichkeit, Entwicklungskontrast, Bildauflösung und Haftung des Resists auf dem Träger.

Hohe Lichtempfindlichkeit ist für einen Photoresist insbesondere dann wichtig, wenn er für Anwendungen eingesetzt wird, bei denen mehrere Belichtungen erforderlich sind, z.B. bei der Erzeugung von Mehrfachbildern in einem Wiederholungsverfahren oder in Fällen, in denen Licht mit abgeschwächter Intensität verwendet wird, z.B. in der Projektionsbelichtungstechnik, bei der das Licht eine Reihe von Objektiven und monochromatischen Filtern durchläuft.

Unter Entwicklungskontrast ist der Unterschied zwischen dem Prozentanteil des Schichtverlusts in den belichteten Bereichen nach dem Entwickeln und dem Prozentanteil des Schichtverlusts in den unbelichteten Bereichen (Dunkelabtrag) zu verstehen. Normalerweise wird ein resistbeschichteter Träger nach dem Belichten so lange entwickelt, bis die Schicht sich in den belichteten Bereichen im wesentlichen vollständig abgelöst hat. Der Entwicklungskontrast kann daher dadurch bestimmt werden, daß nach dem vollständigen Ablösen der belichteten Schichtbereiche der Prozentanteil des Schichtverlusts in den unbelichteten Bereichen gemessen wird.

Unter Auflösung des Resists versteht man die Fähigkeit eines Resistsystems zur Wiedergabe der kleinsten, im gleichen Abstand voneinander angeordneten Linienpaare und der zugehörigen Zwischenräume einer für die Belichtung verwendeten Maske, mit einem hohen Grad an Flankensteilheit des Bildes in den entwickelten belichteten Zwischenräumen.

Für viele technische Anwendungen, insbesondere für die Herstellung von Halbleiterbauelementen in der Mikroelektronik, muß ein Photoresist einen hohen Auflösungsgrad aufweisen, wenn er sehr kleine Linien-und Zwischenraumbreiten (in der Größenordnung von 1 $\mu$m) wiedergeben soll.

Die Fähigkeit eines Resists zur Wiedergabe sehr kleiner Abmessungen in der Größenordnung von 1 $\mu$m und darunter ist bei der Herstellung von LSI-Schaltungen (Large-Scale-Integrated) auf Siliziumchips und ähnlichen Bauteilen von größter Bedeutung. Die Schaltungsdichte auf einem solchen Chip kann bei Einsatz photolithographischer Verfahren nur durch eine Steigerung des Auflösungsvermögens des Resists erhöht werden.

Zur Erzielung der erforderlichen Lichtempfindlichkeit und des gewünschten Kontrastes muß die Konzentration an lichtempfindlichen Verbindungen in dem Photoresistgemisch hoch genug sein, um ein Lösen der unbelichteten Resistbereiche während der Entwicklung zu verhindern. Hohe Konzentrationen an lichtempfindlichen Verbindungen können entweder dadurch erreicht werden, daß man in der Photoresistlösung ein Gemisch aus hochlöslichen und weniger gut löslichen lichtempfindlichen Verbindungen löst oder daß man die Photoresistlösung mit einer lichtempfindlichen Verbindung übersättigt.

Konzentrationen an lichtempfindlicher Verbindung in der Photoresistlösung, die nahe der Sättigungsgrenze liegen, können jedoch die Lagerfähigkeit der Photoresistlösung bedeutend herabsetzen, da die Lösung in diesem Fall zu Instabilität neigt oder ein Ausfallen der lichtempfindlichen Verbindung vor oder bei

der Verwendung des Photoresistgemischs möglich ist. Auf dieses Problem wird in US-A-4,397,937 und US-A-4,526,856 hingewiesen.

Die Kondensationsprodukte aus 1,2-Naphthochinondiazid-4-sulfonsäure und aromatischen Diolen oder Polyolen stellen eine bedeutende Gruppe von lichtempfindlichen Verbindungen dar. Photoresistgemische, die diese Verbindungen enthalten, zeichnen sich bei Belichtung im mittleren UV-Bereich im allgemeinen durch gute Lichtempfindlichkeit und hervorragenden Kontrast aus. Aber auch hier besteht die Neigung zu geringer Löslichkeit und zu Lösungsinstabilität.

In US-A-4,397,937 wird zur Verbesserung der Löslichkeit vorgeschlagen, als lichtempfindliche Verbindung einen Bisester aus einer 1-Oxo-2-diazonaphthalinsulfonsäure und einem unsymmetrischen primären oder sekundären aliphatischen Diol, das ein Gemisch aus geometrischen Isomeren und Diastereoisomeren ist, einzusetzen. Als 1,2-Naphthochinondiazidsulfonsäuren können sowohl die -4-sulfonsäuren, die -5-sulfonsäuren als auch Mischungen der beiden eingesetzt werden, bei denen eine Hydroxylgruppe des unsymmetrischen aliphatischen Diols mit einer 1,2-Naphthochinon-5-sulfonsäure verestert, während die andere Hydroxylgruppe mit einer 1,2-Naphthochinon-4-sulfonsäure verestert wird. Es kommen allerdings nur bestimmte unsymmetrische aliphatische Diole in Betracht.

In US-A-4,526,856 wird versucht, die Probleme, die bei der Erhöhung der Konzentration der lichtempfindlichen Verbindungen auftreten, durch eine Veränderung des Lösemittelsystems der Photoresistgemische zu umgehen. In bestimmten, genau einzuhaltenden Mischungsverhältnissen führt die Verwendung eines Lösemittelgemisches aus Cyclopentanon, bzw. Cyclopentanon und Cyclohexanon, und einem aliphatischen Alkohol zu gutem Lösungsverhalten.

Es war die Aufgabe der vorliegenden Erfindung, ein lichtempfindliches Gemisch vorzuschlagen, welches auch bei höheren Konzentrationen der lichtempfindlichen Verbindung ausgezeichnete Lösungseigenschaften und eine verbesserte Lagerstabilität aufweist, ohne bezüglich der erzielbaren Lichtempfindlichkeit und des Kontrastes Nachteile zu zeigen.

Erfindungsgemäß wird ein lichtempfindliches Gemisch vorgeschlagen, enthaltend ein in wäßrigen Systemen unlösliches, in wäßrig-alkalischen und organischen Lösemitteln lösliches, zumindest aber quellbares Bindemittel sowie eine lichtempfindliche Verbindung, dadurch gekennzeichnet, daß die lichtempfindliche Verbindung ein Kondensationsprodukt ist aus einer Phenolverbindung
der Formel I

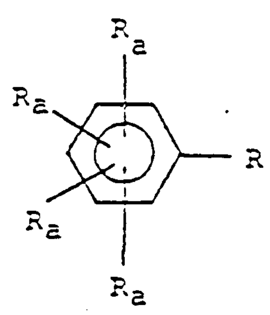

(I)

in der

R Wasserstoff, -X-Rb oder
darstellt,

$R_a$ Wasserstoff, eine OH-Gruppe, Halogen oder eine niedere Alkylgruppe darstellt, wobei mindestens zwei und höchstens sechs $R_a$-Gruppen OH-Gruppen sind,

X eine C-C-Bindung, -O-, -S- $-SO_2-$,

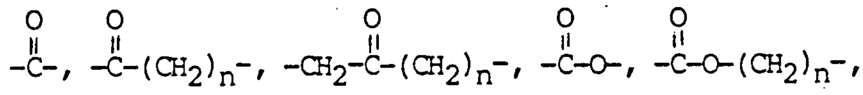

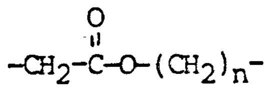, $-(CH_2)_n-$ oder 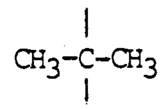

darstellt,

n 1 oder 2 bedeutet und

$R_b$ Wasserstoff oder eine gegebenenfalls substituierte Alkyl- oder Arylgruppe bedeutet;

oder der Formel II

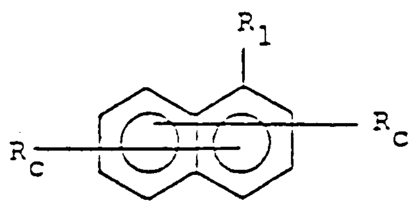

(II)

in der

$R_1$ Wasserstoff oder

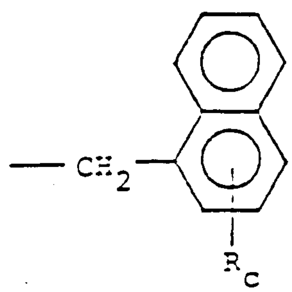

bedeutet und

$R_c$ Wasserstoff, oder eine OH-Gruppe bedeutet, wobei mindestens zwei $R_c$-Gruppen OH-Gruppen sind;

oder der Formel III

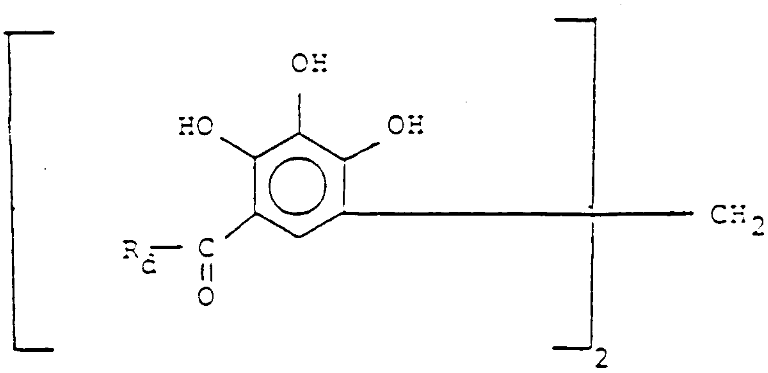

III

in der

$R_d$ Wasserstoff oder eine gegebenenfalls substituierte Alkyl- oder Arylgruppe bedeutet;

mit einer Mischung aus einem 1,2-Naphthochinondiazid-4-sulfonsäurechlorid (Diazoverbindung 1) und einem 1,2-Naphthochinondiazid-5-sulfonsäurechlorid (Diazoverbindung 2).

Erfindungsgemäß wird ferner ein lichtempfindliches Aufzeichnungsmaterial vorgeschlagen, im wesentlichen bestehend aus einem Träger und dem auf ihm aufgetragenen lichtempfindlichen Gemisch.

Erfindungsgemäß wird außerdem ein Verfahren zur Herstellung eines Aufzeichnungsmaterials vorgeschlagen, bei dem ein geeigneter Träger mit einem Photoresistgemisch im wesentlichen bestehend aus einem Bindemittel und einer lichtempfindlichen Verbindung der vorstehend beschriebenen Art beschichtet wird, der beschichtete Träger mittels UV-Strahlung bildmäßig belichtet wird, und schließlich die belichteten Schichtteile mit einem wäßrig-alkalischen Entwickler vom Träger entfernt werden.

Erfindungsgemäß wird dem Ausfallen der lichtempfindlichen Verbindungen und der damit verbundenen Instabilität und geringen Lagerfähigkeit von Photoresistlösungen dadurch entgegengewirkt, daß Mischester aus Phenolverbindungen mit 1,2-Naphthochinondiazid-4-und -5-sulfonsäuren eingesetzt werden. Beim Einsatz dieser Mischester aus Diazoverbindung 1 und Diazoverbindung 2 mit einem alkalilöslichen Bindemittel erhöht sich die Haltbarkeit und Lagerfähigkeit der Gemische, wobei im Vergleich mit anderen lichtempfindlichen Gemischen, die lediglich Ester der Diazoverbindung 1 enthalten, die Lichtempfindlichkeit und der Entwicklungskontrast nicht reduziert sind.

Die erfindungsgemäßen lichtempfindlichen Verbindungen werden durch Kondensation von Phenolverbindungen mit einem Gemisch aus den Sulfonsäurechloriden vom Typ Diazoverbindung 1 und Diazoverbindung 2 erhalten. Das Molverhältnis von Diazoverbindung 1 zu Diazoverbindung 2 in dem Gemisch liegt zwischen 1,5:1 und 39:1, bevorzugt zwischen 4:1 und 19:1, insbesondere zwischen 85:15 und 93:7. Beispielsweise wird 1 Mol Trihydroxybenzophenon mit einem Gemisch im Mischungsverhältnis 9:1 aus 2,7 Mol Diazoverbindung 1 und 0,3 Mol Diazoverbindung 2 kondensiert. Die erhaltene lichtempfindliche Verbindung umfaßt Einheiten der allgemeinen Formel

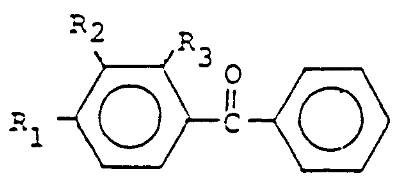

in der $R_1$, $R_2$ und $R_3$ unabhängig voneinander jeweils eine 1,2-Naphthochinondiazid-4-sulfonylgruppe (Diazoverbindung 1) oder eine 1,2-Naphthochinondiazid-5-sulfonylgruppe (Diazoverbindung 2) bedeuten können.

Die Umsetzung des Gemisches aus Diazoverbindung 1 und Diazoverbindung 2 mit den Phenolverbindungen erfolgt vorzugsweise in stöchiometrischen Verhältnissen. Doch müssen die Phenolverbindungen nicht vollständig verestert sein; es können auch kleinere als stöchiometrische Mengen an Diazoverbindung 1 und Diazoverbindung 2 mit den Phenolverbindungen umgesetzt werden.

Die Gesamtmenge der mit den Phenolverbindungen umgesetzten Diazoverbindungen 1 und 2 sollte so bemessen sein, daß eine lichtempfindliche Verbindung erhalten wird, die eine ausreichende Löslichkeit des lichtempfindlichen Gemisches in alkalischem Medium nach dem Belichten gewährleistet.

Die Phenolverbindungen, die für die Kondensation mit dem Gemisch aus Diazoverbindung 1 und Diazoverbindung 2 geeignet sind, entsprechen den nachstehend beschriebenen allgemeinen Formeln I, II oder III:

I)

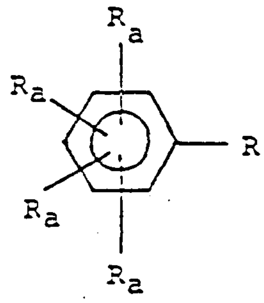

(I)

in der

R Wasserstoff, $-X-R_b$ oder

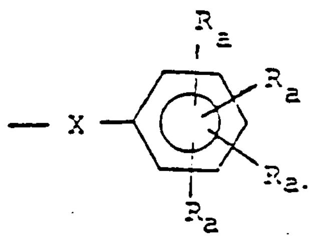

darstellt,

$R_a$ Wasserstoff, eine OH-Gruppe, Halogen, insbesondere Chlor oder Brom oder eine niedere Alkylgruppe mit vorzugsweise 1 bis 4 C-Atomen darstellt, besonders bevorzugt Wasserstoff oder OH-Gruppen, wobei mindestens zwei und höchstens sechs $R_a$-Gruppen OH-Gruppen sind,

X eine C-C-Bindung, -O-, -S- $-SO_2-$,

$$-\overset{O}{\overset{\|}{C}}-,\ -\overset{O}{\overset{\|}{C}}-(CH_2)_n-,\ -CH_2-\overset{O}{\overset{\|}{C}}-(CH_2)_n-,\ -\overset{O}{\overset{\|}{C}}-O-,\ -\overset{O}{\overset{\|}{C}}-O-(CH_2)_n-,$$

$$-CH_2-\overset{O}{\overset{\|}{C}}-O-(CH_2)_n-,\ -(CH_2)_n-\ \text{oder}\ CH_3-\underset{|}{\overset{|}{C}}-CH_3,\ \text{vorzugsweise}\ -\overset{O}{\overset{\|}{C}}-$$

darstellt,

n 1 oder 2 bedeutet und

$R_b$ Wasserstoff oder eine gegebenenfalls substituierte Alkyl- oder Arylgruppe bedeutet, wobei die Alkylgruppe bevorzugt 1 bis 20, insbesondere 1 bis 12 C-Atome besitzt, die Arylgruppe bevorzugt eine Phenyl- oder eine Naphthylgruppe ist, und die Alkyl-, bzw. Arylgruppe als Substituenten gegebenenfalls niedere Alkylgruppen mit 1 bis 4 C-Atomen, niedere Alkoxygruppen mit 1 bis 4 C-Atomen oder Halogenatome, insbesondere Chlor oder Brom, aufweisen; besonders bevorzugt ist eine unsubstituierte Phenylgruppe;

II)

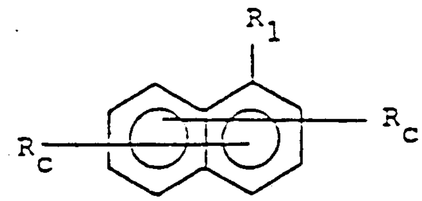

(II)

in der

$R_1$ Wasserstoff oder

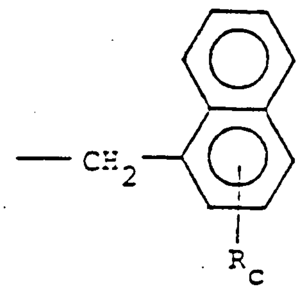

bedeutet und

$R_c$ Wasserstoff oder eine OH-Gruppe bedeutet, wobei mindestens zwei $R_c$-Gruppen OH-Gruppen sind; oder

III)

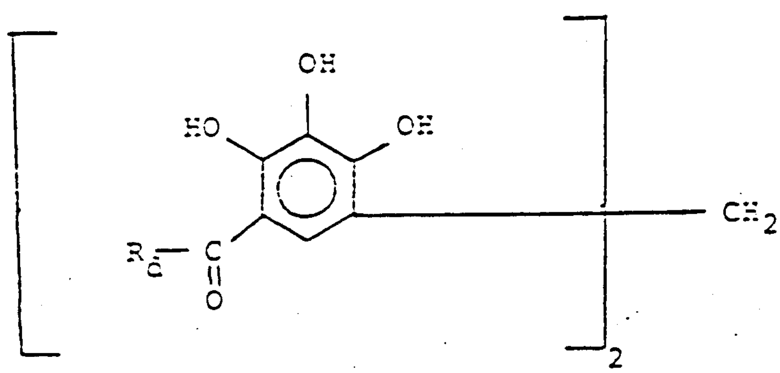

(III)

in der

$R_d$ Wasserstoff oder eine gegebenenfalls substituierte Alkyl- oder Arylgruppe bedeutet, wobei die Alkylgruppe bevorzugt 1 bis 20 C-Atome besitzt, gerade oder verzweigt sein kann und gegebenenfalls Halogenatome oder niedere Alkoxygruppen mit 1 bis 4 C-Atomen als Substituenten aufweist; die Arylgruppe bevorzugt 6 bis 10 C-Atome besitzt, bevorzugt einkernig ist und gegebenenfalls niedere Alkyl- oder Alkoxygruppen mit 1 bis 4 C-Atomen oder Halogenatome als Substituenten aufweist. Dabei werden Verbindungen, in denen $R_d$ eine Arylgruppe, insbesondere eine Phenylgruppe darstellt, bevorzugt.

Zu den Phenolverbindungen nach der allgemeinen Formel (I) zählen vorzugsweise:

Hydroxylgruppentragende Benzolverbindungen, wie z.B.

1,2-Dihydroxybenzol,

1,3-Dihydroxybenzol,
1,4-Dihydroxybenzol,
1,2,3-Trihydroxybenzol,
1,2,4-Trihydroxybenzol,
1,3,5-Trihydroxybenzol usw.;
Dihydroxybenzophenone, wie z.B.
2,2′-Dihydroxybenzophenon,
2,3′-Dihydroxybenzophenon,
2,4-Dihydroxybenzophenon,
2,4′-Dihydroxybenzophenon,
2,5-Dihydroxybenzophenon,
3,3′-Dihydroxybenzophenon,
4,4′-Dihydroxybenzophenon, usw.;
Trihydroxybenzophenone, wie z.B.
2,2′,6-Trihydroxybenzophenon,
2,3,4-Trihydroxybenzophenon,
2,4,4′-Trihydroxybenzophenon,
2,4,6-Trihydroxybenzophenon,
3,4,5-Trihydroxybenzophenon, usw.;
Tetrahydroxybenzophenone, wie z.B.
2,2′,3,4-Tetrahydroxybenzophenon,
2,2′4,4′-Tetrahydroxybenzophenon,
2,2′,4,6′-Tetrahydroxybenzophenon,
2,2′,5,6′-Tetrahydroxybenzophenon,
2,3′,4,4′-Tetrahydroxybenzophenon,
2,3′,4,6-Tetrahydroxybenzophenon,
2,4,4′,6-Tetrahydroxybenzophenon,
3,3′,4,4′-Tetrahydroxybenzophenon, usw.;
Pentahydroxybenzophenone;
Hexahydroxybenzophenone;
Dihydroxy- und Trihydroxy-phenyl-alkyl-ketone, wie z.B.
2,4-Dihydroxyphenyl-alkyl-ketone,
2,5-Dihydroxyphenyl-alkyl-ketone,
3,4-Dihydroxyphenyl-alkyl-ketone,
3,5-Dihydroxyphenyl-alkyl-ketone,
2,3,4-Trihydroxyphenyl-alkyl-ketone,
3,4,5-Trihydroxyphenyl-alkyl-ketone,
2,4,6-Trihydroxyphenyl-alkyl-ketone, usw.
wobei vorzugsweise Alkylgruppen mit 1 bis 12 C-Atomen, die gegebenenfalls verzweigt sind, eingesetzt werden, wie z.B. Methyl, Ethyl, Butyl, n-Hexyl, Heptyl, Decyl, Dodecyl, usw.;
Dihydroxyphenyl-aralkyl-ketone;
Trihydroxyphenyl-aralkyl-ketone;
Dihydroxydiphenyle;
Trihydroxydiphenyle, wie z.B.
2,2′,4-Trihydroxydiphenyl;
Tetrahydroxydiphenyle, wie z.B.
2,2′,4,4′-Tetrahydroxydiphenyl;
Dihydroxydiphenylether;
Dihydroxydibenzylether;
Dihydroxydiphenylalkane, vorzugsweise mit niederen Alkylenketten, wie z.B. Methylen, Ethylen, Propylen usw.;
Dihydroxybenzoesäure;
Trihydroxybenzosäuren;
Dihydroxy- und Trihydroxy-benzoesäurealkylester, wobei die Alkylgruppe vorzugsweise 1 bis 12 C-Atome, insbesondere 1 bis 8 C-Atome besitzt, wie z.B.
n-Butyl-2,4-, -2,5-, -3,4- und -3,5-dihydroxybenzoat,
2,4,4-Trimethylpentyl-2,4-dihydroxybenzoat, usw.;
Dihydroxy- und Trihydroxybenzoesäurephenylester;

Dihydroxy-, Trihydroxy-, und Tetrahydroxydiphenylsulfide,
wie z.B. 4,4′-Dihydroxydiphenylsulfid;
Dihydroxydiphenylsulfone;
Dihydroxy- und Trihydroxyphenylnaphthylketone, wie z.B.
2,3,4-Trihydroxyphenylnaphthyl-1-keton;
und ähnliche Verbindungen.

Zu den Verbindungen der allgemeinen Formel (I), bei denen wenigstens eine $R_a$-Gruppe ein Halogenatom oder eine niedere Alkylgruppe darstellt, gehören beispielsweise
2,4-Dihydroxy-3,5-dibrombenzophenon, 5-Brom-2,4-dihydroxybenzoesäure und ihre Ester, 2,4,2′,4′-Tetrahydroxy-3,5,3′,5′-tetrabromdiphenyl, 4,4′-Dihydroxy-2,2′-dimethyl-5,5′-di-tert.-butyldiphenyl, 4,4′-Dihydroxy-2,2'-dimethyl-5,5′-di-tert.butyldiphenylsulfid, 2,4,2′,4′-Tetrahydroxy-3,5,3′,5′-tetrabromodiphenylsulfon und ähnliche Verbindungen.

Die Hydroxylgruppen enthaltenden Benzophenone, insbesondere die Trihydroxybenzophenone, werden als Phenolverbindungen der allgemeinen Formel (I) bevorzugt eingesetzt.

Zu den Phenolverbindungen der allgemeinen Formel (II) gehören vorzugsweise folgende Verbindungen:
Dihydroxynaphthaline, wie z.B.
1,2-Dihydroxynaphthalin,
1,4-Dihydroxynaphthalin,
1,5-Dihydroxynaphthalin,
1,6-Dihydroxynaphthalin,
1,7-Dihydroxynaphthalin,
1,8-Dihydroxynaphthalin,
2,3-Dihydroxynaphthalin,
2,6-Dihydroxynaphthalin,
2,7-Dihydroxynaphthalin, usw.;
Dihydroxydinaphthylmethane, wie z.B.
2,2′-Dihydroxydinaphthylmethan usw.
Die Dihydroxynaphthaline werden bevorzugt eingesetzt.
Die Hydroxylgruppen der Dihydroxynaphthaline können sich dabei sowohl an einem Kern, als auch an beiden Kernen des Naphthalinmoleküls befinden.

Zu den Phenolverbindungen der allgemeinen Formel (III) gehören vorzugsweise folgende Verbindungen:
Bis-(3-benzoyl-4,5,6-trihydroxyphenyl)-methan,
Bis-(3-acetyl-4,5,6-trihydroxyphenyl)-methan,
Bis-(3-propionyl-4,5,6-trihydroxyphenyl)-methan,
Bis-(3-butyryl-4,5,6-trihydroxyphenyl)-methan,
Bis-(3-hexanoyl-4,5,6-trihydroxyphenyl)-methan,
Bis-(3-heptanoyl-4,5,6-trihydroxyphenyl)-methan,
Bis-(3-decanoyl-4,5,6-trihydroxyphenyl)-methan und
Bis-(3-octadecanoyl-4,5,6-trihydroxyphenyl)-methan, usw.

Die Herstellung der erfindungsgemäßen lichtempfindlichen Gemische, insbesondere von Photoresists, erfolgt durch Mischen der lichtempfindlichen Verbindungen mit alkalilöslichen Bindemitteln, Lösemitteln und gegebenenfalls weiteren Zusätzen. Geeignete alkalilösliche Bindemittel sind beispielsweise Novolake und Polyvinylphenole.

Alkalilösliche Novolake, die für die Herstellung von lichtempfindlichen Gemischen verwendet werden können, sind bekannt. Ein Verfahren zur Herstellung dieser Novolake ist in "Chemistry and Application of Phenolic Resins" (Chemie und Anwendung von Phenolharzen), von A. Knop und W. Scheib, Springer Verlang, New York, 1979, Kapitel 4, beschrieben.

Für die Herstellung der erfindungsgemäßen lichtempfindlichen Gemische werden der Novolak oder das Polyvinylphenol und die lichtempfindliche Verbindung in einem Lösemittel gelöst. Hierfür geeignete Lösemittel sind beispielsweise Glykolether, wie z.B. Ethylenglykolmonomethylether und Ethylenglykolmonoethylether oder auch deren Acetate wie Propylenglykolmethyletheracetat; Ester, wie z.B. Ethylacetat und Butylacetat; Ketone, wie z.B. Methylethylketon, Cyclopentanon und Cyclohexanon; sowie aromatische Kohlenwasserstoffe, wie z.B. Toluol und Xylol. Gemische aus diesen Lösemitteln können ebenfalls eingesetzt werden. Die genaue Auswahl des Lösemittels, bzw. Lösemittelgemisches, hängt im Einzelfall unter anderem von dem jeweiligen Beschichtungsverfahren, der gewünschten Schichtdicke, den Trocknungsbedingungen, der Löslichkeit der einzelnen Komponenten und der Verdunstungsgeschwindigkeit des Lösemittels nach der Beschichtung des Trägers mit dem Photoresistgemisch ab.

Dem erfindungsgemäßen lichtempfindlichen Gemisch können vor dem Aufbringen auf einen Schichtträger noch Zusätze, wie z.B. Farbmittel, Farbstoffe, Verlaufmittel, Weichmacher, Haftvermittler, Entwicklungsbeschleuniger und Tenside, z.B. nicht-ionische Tenside, zugegeben werden.

In bevorzugter Ausführung liegt der Gehalt an festen Bestandteilen des lichtempfindlichen Gemisches für den Novolak oder das Polyvinylphenol bei etwa 15 bis 99 Gewichtsprozent, für die lichtempfindliche Verbindung bei etwa 1 bis 85 Gewichtsprozent. Insbesondere ist das Bindemittel in einem Anteil von etwa 50 bis 97 Gewichtsprozent, und ganz besonders bevorzugt von etwa 65 bis 93 Gewichtsprozent, bezogen auf das Gewicht der festen Bestandteile, in dem Gemisch enthalten. Der Anteil an lichtempfindlicher Verbindung liegt insbesondere bei etwa 3 bis 50 Gewichtsprozent und ganz besonders bevorzugt bei etwa 7 bis 35 Gewichtsprozent, bezogen auf das Gewicht der festen Bestandteile des Gemischs. Zur Herstellung des lichtempfindlichen Gemisches werden das Bindemittel und und die lichtempfindliche Verbindung so mit dem Lösemittel gemischt, daß das Lösemittel in einem Anteil von etwa 40 bis 90 Gewichtsprozent, vorzugsweise von etwa 60 bis 85 Gewichtsprozent, und insbesondere von etwa 65 bis 80 Gewichtsprozent, jeweils bezogen auf das Gewicht des gesamten Gemisches, vorhanden ist.

Farbstoffe, die als Zusätze für die erfindungsgemäßen Photoresistgemische verwendet werden können, sind zum Beispiel Methylviolett 2B (C.I. 42 535), Kristallviolett (C.I. 42 555), Malachitgrün (C.I. 42 000), Victoriablau B (C.I. 44 045) und Neutralrot (C.I. 50 040). Diese Farbstoffe werden in einer Menge von 1 bis 10 Gewichtsprozent, bezogen auf das gemeinsame Gewicht von Bindemittel und lichtempfindlicher Verbindung, zugesetzt. Die Farbstoffzusätze verringern die Rückstreuung von Licht vom Träger und tragen so zu einer verbesserten Auflösung bei.

Verlaufmittel können in einer Menge bis zu 5 Gewichtsprozent, bezogen auf das gemeinsame Gewicht von Bindemittel und lichtempfindlicher Verbindung, eingesetzt werden.

Geeignete Weichmacher sind zum Beispiel Phosphorsäuretri($\beta$-chlorethyl)-ester, Stearinsäure, Dicampher, Polypropylen, Acetalharze, Phenoxyharze und Alkydharze, die in Anteilen von 1 bis 10 Gewichtsprozent, bezogen auf das gemeinsame Gewicht von Bindemittel und lichtempfindlicher Verbindung, zugesetzt werden können. Die Weichmacherzusätze verbessern die Beschichtungseigenschaften des Gemischs und ermöglichen das Auftragen in einer glatten und gleichmäßig dicken Schicht auf den Schichtträger.

Geeignete Haftvermittler zur besseren Haftung des Gemisches auf dem Träger sind zum Beispiel $\beta$-(3,4-Epoxycyclohexyl)-ethyltrimethoxysilan, p-Methyldisilanmethylmethacrylat, Vinyltrichlorsilan und $\gamma$-Aminopropyltrieth-oxysilan in einem Anteil bis zu 4 Gewichtsprozent, bezogen auf das gemeinsame Gewicht von Bindemittel und lichtempfindlicher Verbindung.

Als Entwicklungsbeschleuniger können beispielsweise Pikrinsäure, Nicotinsäure oder Nitrozimtsäure in einem Anteil bis zu 20 Gewichtsprozent, bezogen auf das gemeinsame Gewicht von Bindemittel und lichtempfindlicher Verbindung, zugegeben werden. Diese Be-schleuniger führen dazu, daß die Löslichkeit der lichtempfindlichen Schicht sowohl in den belichteten als auch in den unbelichteten Bereichen zunimmt. Sie werden deshalb bei solchen Anwendungen eingesetzt, bei denen es in erster Linie auf die Entwicklungsgeschwindigkeit ankommt. Während die belichteten Bereiche der Photoresistschicht durch den Zusatz von Beschleunigern vom Entwickler schneller gelöst werden, bewirken die Entwicklungsbeschleuniger gleichzeitig aber auch einen größeren Verlust an Photoresistschicht aus den unbelichteten Bereichen, so daß eventuell ein gewisser Grad an Kontrast verloren geht.

Als nicht-ionische Tenside können zum Beispiel
Nonylphenoxy-poly(ethylenoxy)-ethanol,
Octylphenoxy(ethylenoxy)-ethanol, und
Dinonylphenoxy-poly(ethylenoxy)-ethanol in einem Anteil bis zu 10 Gewichtsprozent, bezogen auf das gemeinsame Gewicht vom Bindemittel und lichtempfindlicher Verbindung, verwendet werden.

Erfindungsgemäß wird ferner ein lichtempfindliches Aufzeichnungsmaterial vorgeschlagen, bestehend aus dem oben beschriebenen lichtempfindlichen Gemisch und einem Träger, sowie ein Verfahren zur Herstellung des Aufzeichnungsmaterials:

Das lichtempfindliche Gemisch kann nach einem der in der Photoresisttechnik üblichen Verfahren, wie Tauchen, Sprühen und Aufschleudern, auf einen Träger aufgebracht werden. Beim Aufschleudern kann zum Beispiel der Prozentanteil an Feststoffen in der Resistlösung so eingestellt werden, daß sich in Abhängigkeit von der im Einzelfall verwendeten Aufschleudervorrichtung und der für den Aufschleudervorgang angesetzten Zeitspanne eine Beschichtung in der gewünschten Dicke ergibt. Beispiele für geeignete Trägermaterialien sind: Silicium, Aluminium oder polymere Harze, Siliciumdioxid, dotiertes Siliciumdioxid, Siliciumnitrid, Tantal, Kupfer, polykristallines Silicium (polysilicon), Keramik und Aluminium/Kupfer-Legierungen.

Die nach dem beschriebenen Verfahren hergestellten lichtempfindlichen Gemische eignen sich insbesondere zum Auftragen auf Silicium-Wafern, die eine Schicht aus thermisch gezüchtetem Siliciumdioxid tragen, wie sie bei der Herstellung von Mikroprozessoren und anderen in der Mikroelektronik verwendeten

Halbleiterbauelementen verwendet werden. Ebenso kann auch ein Wafer aus Aluminium mit einer Aluminiumoxidschicht eingesetzt werden. Der Träger kann auch aus verschiedenen polymeren Harzen, insbesondere aus transparenten Polymeren, wie zum Beispiel Polyestern, bestehen.

Nach dem Auftragen des lichtempfindlichen Gemisches auf den Schichtträger wird der Träger einer Vortrocknung bei etwa 80 bis 105 °C unterworfen. Diese Wärmebe-handlung wird so lange fortgeführt, bis das Lösemittel im wesentlichen vollständig verdampft ist und eine dünne Schicht von etwa 1 µm auf dem Schichtträger zurückbleibt.

Der beschichtete Träger wird anschließend in bekannter Weise mittels aktinischer Strahlung, insbesondere UV-Strahlung, durch geeignete Masken, Negative, Schablonen, usw. bildmäßig belichtet.

Die bildmäßig belichteten Aufzeichnungsmaterialien werden in eine wäßrig-alkalische Entwicklerlösung getaucht, wobei die Lösung vorzugsweise durch Durchblasen von Stickstoff stark bewegt wird.

Nach dem Herausnehmen der beschichteten Wafer aus der Entwicklerlösung kann eine Wärmenachbehandlung bzw. Einbrennbehandlung durchgeführt werden, um die Haftung und die chemische Beständigkeit der Schicht gegen Ätzlösungen und andere Substanzen zu erhöhen. Die Wärmebehandlung nach dem Entwickeln kann aus einer Ofenhärtung von Schicht und Träger bei Temperaturen unterhalb des Erweichungspunktes der Schicht bestehen.

Für industrielle Anwendungen, insbesondere bei der Herstellung von Halbleiterbauelementen auf Siliciumträgern mit einer Siliciumdioxidschicht können die entwickelten Träger mit einer gepufferten Ätzlösung auf der Basis von Flußsäure behandelt werden. Die erfindungsgemäßen Photoresistgemische sind gegen derartige Ätzlösungen auf Säurebasis resistent und gewährleisten einen wirksamen Schutz der unbelichteten, mit dem Photoresistgemisch beschichteten Stellen des Trägers.

Die erfindungsgemäßen lichtempfindlichen Gemische eignen sich bevorzugt als Photoresistgemische. Sie können allerdings auch als lichtempfindliche Gemische für die Druckplattenherstellung und für Farbprüffolien Verwendung finden.

In den folgenden Beispielen werden die Verfahren zur Herstellung und Anwendung von den erfindungsgemäßen Gemischen eingehend erläutert.

## Herstellung lichtempfindlicher Verbindungen

Die Herstellung von lichtempfindlichen Verbindungen auf der Basis von Naphthochinondiaziden ist beispielhaft in US-A-3,046,118, US-A-3,106,645 und US-A-4,397,937 beschrieben. Die lichtempfindlichen Verbindungen für das erfindungsgemäße lichtempfindliche Gemisch werden durch Kondensation der den Diazoverbindungen 1 und 2 entsprechenden 1,2-Naphthochinondiazidsulfonsäurechloriden mit einer mehr als eine Hydroxylgruppe enthaltenden Phenolverbindung des Typs I bis III in Gegenwart einer säurebindenden Substanz hergestellt. Die so erhaltenen lichtempfindlichen Verbindungen können gegebenenfalls noch gereinigt werden.

Für die Durchführung der Reaktion geeignete Lösungsmittel sind beispielsweise Aceton, p-Dioxan, Tetrahydrofuran, Methylenchlorid, Pyridin, usw.

Die Säure bindende Substanz kann anorganisch sein, z.B. Natriumcarbonat, oder organisch, z.B. ein Natriumsalz einer schwachen organischen Säure, ein tertiäres Amin, z.B. Triethylamin oder ein Pyridin(derivat).

## Beispiel 1

Es wird ein mit 10 Mol-% Diazoverbindung 2 modifizierter 2,3,4-Trihydroxybenzophenon-1,2-naphthochinondiazidsulfonsäuretriester hergestellt. Dafür werden 23,0 g 2,3,4-Trihydroxybenzophenon und 72,6 g 1,2-Naphthochinondiazid-4-sulfonsäurechlorid (Diazoverbindung 1) in 350 ml Aceton miteinander verrührt. 8,06 g 1,2-Napthochinondiazid-5-sulfonsäurechlorid (Diazoverbindung 2) werden hinzugefügt. Dann werden 36,4 g Triethylamin langsam tropfenweise zugegeben, wobei die Innentemperatur bei 30 °C gehalten wird. Anschließend wird das Reaktionsgemisch auf eine Temperatur unter 15 °C abgekühlt, mit Aktivkohle und Kieselgur behandelt, filtriert, mit 350 ml Aceton gewaschen und in 3,5 Liter l N Salzsäure aufgenommen. Das Reaktionsprodukt wird abgefiltert, mit Wasser gewaschen und in einem Umluftschrank bei einer Temperatur unter 40 °C getrocknet. Die Ausbeute beträgt 92,3 g, entsprechend 99,6 % d.Th.

Das so erhaltene Produkt kann gegebenenfalls noch gereinigt werden.

Das beschriebene Herstellungsverfahren ist nicht das einzig mögliche. Jeder Fachmann kann durch Variieren der verwendeten Lösemittel, Basen oder Reaktionsbedingungen ohne weiteres zu vergleichbaren Produkten gelangen.

Nach dem vorstehend beschriebenen Verfahren werden eine Reihe von Kondensationsprodukten hergestellt, in denen die Molverhältnisse der Diazoverbindungen 1 und 2 entsprechend den Tabellen 1 und 2 geändert werden.

Zum Vergleich wird 2,3,4-Trihydroxybenzophenon mit 1,2-Naphthochinondiazid-4-sulfonylchlorid im Molverhältnis 1:3 kondensiert.

Lösungsstabilität

Nach dem bereits beschriebenen Verfahren werden lichtempfindliche Gemische hergestellt. Die Gemische mit den unterschiedlichen lichtempfindlichen Verbindungen werden in einer gefilterten Lösung aus 24 % Novolakharz und 76 % Propylenglykolmethyletheracetat (PGMEA) gelöst. Die Resistgemische werden so eingestellt, daß das Absorptionsvermögen der lichtempfindlichen Verbindung bei einer Wellenlänge von 377 nm 1,0 l/g • cm beträgt. Wenn beispielsweise eine Probe von 30 mg 2,3,4-Trihydroxybenzophenon-1,2-naphthochinondiazid-4-sulfonsäuretriester in einem Liter Aceton bei 377 nm ein Absorptionsvermögen von 0,731 besitzt, hat das Photoresistgemisch folgende Zusammensetzung:

| | |
|---|---|
| 4,1 % | lichtempfindliche Verbindung |
| 23,0 % | Novolakharz |
| 72,9 % | PGMEA |

Die Photoresist-Versuchslösungen werden zunächst durch ein Ertel-Filter Nr. 8 und anschließend durch ein Fluoropore-Filter (Herst. Millipore Corporation) mit Filteröffnungen von 0,2 bis 0,5 µm Durchmesser abfiltriert. Die Versuchslösungen werden unter Lichtausschluß 5 Tage in einem Trockenschrank bei einer konstanten Temperatur von 50 °C gelagert, anschließend wird untersucht, ob sich ein sichtbarer Niederschlag abgesetzt hat. Falls ja, hat die jeweilige Lösung die Stabilitätsprüfung nicht bestanden. Die Testergebnisse für eine Reihe modifizierter und unmodifizierter Photoresistgemische sind in der nachstehenden Tabelle 1 zusammengefaßt.

Tabelle 1

| Lichtempfindl. Verbindung | Modifizierung (1) (Mol-%) | Lösungsstabilität |
|---|---|---|
| A | keine | nicht bestanden |
| B | keine | nicht bestanden |
| C | keine | nicht bestanden |
| D | 2,5 | bestanden |
| E | 2,5 | bestanden |
| F | 5 | bestanden |
| G | 5 | bestanden |
| H | 10 | bestanden |
| I | 10 | bestanden |
| J | 10 | bestanden |
| L | 20 | bestanden |
| M | 20 | bestanden |

(1) Die lichtempfindlichen Verbindungen A bis M wurden durch Umsetzen von 2,3,4-Trihydroxybenzophenon mit der stöchiometrischen Menge eines Gemischs aus den Diazoverbindungen 1 und 2 hergestellt. Die Zahlen in dieser Spalte geben die jeweilige Menge an Diazoverbindung 2 in den Gemischen an. In den Versuchen, in denen keine Modifizierung stattfand, wurde das 2,3,4-Trihydroxybenzophenon nur mit Diazoverbindung 1 kondensiert.

Aus der Tabelle ist ersichtlich, daß die modifizierten lichtempfindlichen Verbindungen Gemische mit besserer Lösungsstabilität ergeben als die unmodifizierten lichtempfindlichen Verbindungen.

Lagerfähigkeit

Die Bestimmung der Lagerfähigkeit einzelner lichtempfindlicher Gemische bei Raumtemperatur ist sehr zeitaufwendig und daher auch unpraktisch. Im allgemeinen wird die Lösungsstabilität als relatives Maß für die Lagerfähigkeit einer eine bestimmte lichtempfindliche Verbindung enthaltenden Photoresistlösung verwendet. Doch werden für einige der Gemische dennoch "echte" Lagerfähigkeitstests durchgeführt. Hierfür werden die Gemische bei Raumtemperatur gelagert und von Zeit zu Zeit wird geprüft, ob Ablagerungen erkennbar sind. In der Regel fällt die unmodifizierte, d.h., nur die Diazoverbindung 1 enthaltende, lichtempfindliche Verbindung nach etwa 6 Wochen aus; in praktisch allen Fällen ist bei diesen Verbindungen vor Ablauf von 3 Monaten eine Ausfällung zu beobachten. Die einzelnen Ergebnisse des dreimonatigen Lagerungstests sind nachstehend in Tabelle 2 angegeben.

Tabelle 2

| Lichempfindl. Verbindung | Modifizierung(1) (Mol-%) | Lösungsstabilität(2) (Lagerfähigkeit) |
|---|---|---|
| B | keine | nicht bestanden |
| N | keine | nicht bestanden |
| K | keine | nicht bestanden |
| I | 10 | bestanden |
| J | 10 | bestanden |
| L | 20 | bestanden |
| M | 20 | bestanden |

(1) s. Tabelle 1

(2) Die Proben wurden nach drei Monaten untersucht. "Nicht bestanden" bedeutet, daß eine Ausfällung sichtbar stattfand, "bestanden" bedeutet, daß keine Ausfällung erkennbar war.

Die Angaben zeigen, daß die modifizierten lichtempfindlichen Verbindungen im Vergleich mit der unmodifizierten, nur die Diazoverbindung 1 enthaltenden lichtempfindlichen Verbindung eine weitaus geringere Ausfällungsneigung zeigen. Folglich besitzen die mit den erfindungsgemäßen lichtempfindlichen Verbindungen hergestellten Photoresistgemische eine erhöhte Lagerfähigkeit.

Beispiel 2

Mit den erfindungsgemäßen lichtempfindlichen Gemischen werden Resistansätze formuliert und so eingestellt, daß das Absorptionsvermögen der lichtempfindlichen Verbindung bei einer Wellenlänge von 377 nm 0,76 ± 0,025 l/g • cm beträgt. Die jeweils zu prüfende lichtempfindliche Verbindung wird in einer gefilterten Stammlösung aus 24 % Novolakharz und 76 % Propylenglykolmethyletheracetat gelöst. Anschießend werden die Resistlösungen durch ein Ertel-Filter Nr. 8 filtriert.

Die Photoresistgemische werden zu einer Trockenschichtdicke von 2,0 µm auf Siliciumwafer aufgeschleudert. Die Wafer werden bei 90 °C 30 Minuten getrocknet.

Die ursprüngliche Dicke der Photoresistschichten wird mit einem Rudolph-Dickenmeßgerät ermittelt. Anschließend wird mit unterschiedlichen Dosen UV-Licht (350-450 nm) belichtet. Die Photoresists werden 1 Minute bei 25 °C mit einem metallionenhaltigen alkalischen Entwickler aus KOH und Borsäure, der im Verhältnis 1:3 mit entionisiertem Wasser verdünnt wurde, entwickelt. Bei dieser Entwicklerkonzentration kann der Dunkelabtrag oder Grad der Abtragung nicht-belichteter Resistschichtteile durch den Entwickler im allgemeinen bei 0,005 bis 0,015 µm pro Minute gehalten werden. Anschließend wird die verbliebene Schichtdicke gemessen und so der bei der jeweiligen Energiedosis auftretende Schichtverlust bestimmt.

Die Lichtempfindlichkeit wird anhand einer Kennkurve nach R.W. Wake und M.C. Flanigan, "A Review of Contrast in Positive Photoresists," SPIE Bd. 539, Advances in Resist Technology and Processing II (1985, S. 291) gemessen, wobei der Schichtdickenverlust nach einer Entwicklungsdauer von einer Minute gegen den Logarithmus der UV-Belichtungsdosis aufgetragen wird. Durch Interpolieren dieser Kurve auf einen Schichtdickenverlust von 1 µm wird der jeweilige Lichtempfindlichkeitswert in $mJ/cm^2$ erhalten. Die Neigung des linearen Teils der Kurve gibt den Kontrast an.

Die Ergebnisse, die bei der Prüfung der Lichtempfindlichkeit, des Konstrasts und des Dunkelabtrags mehrerer Photoresistgemische erzielt werden, in denen erfindungsgemäß lichtempfindliche Verbindungen enthalten sind, sind in Tabelle 3 zusammenfassend dargestellt und werden mit Photoresistgemischen verglichen, die nichtmodifizierte lichtempfindliche Verbindungen enthalten. Statistische Vergleichswerte werden erhalten, indem man drei Photoresistproben untersucht, die einen unmodifizierten 2,3,4-Trihydroxybenzophenon-1,2-naphthochinondiazid-4-sulfonsäuretriester (nur mit Diazoverbindung 1 hergestellt) enthalten. Jede Probe wird dreimal einer Lichtempfindlichkeits- und Kontrastmessung unterzogen, so daß insgesamt 9 Datensätze erhalten werden. Der Abweichungsbereich der Lichtempfindlichkeit ($mJ/cm^2$) von der mittleren Lichtempfindlichkeit beträgt ± 10 %. Die absolute Differenz zwischen dem höchsten und dem niedrigsten Lichtempfindlichkeitswert beträgt 20 Prozent, bezogen auf den unteren Wert. Auch der Abweichungsbereich der einzelnen Kontrastwerte vom Mittelwert beträgt ± 10 Prozent; die absolute Differenz zwischen dem höchsten und niedrigsten Meßwert beträgt in diesem Fall 24 Prozent, ebenfalls bezogen auf den unteren Wert.

Die in Tabelle 3 dargestellten Prüfungsergebnisse zeigen, daß die erfindungsgemäß hergestellten Photoresistgemische auch bezüglich ihrer Kopiereigenschaften den analogen unmodifizierten Gemischen nicht nachstehen.

Tabelle 3

| Lichtempfindl. Verbindung Nr. | Modifizierung (Mol-%) | Absorptionsvermögen (1/g · cm bei 377 nm) | Dunkelabtrag (µm/min.) | Lichtempfindlichkeit (1) (% höher(−), bzw. niedriger (+) als Vergleichswert) | Bildkontrast (2) (% höher (+), bzw. niedriger (−) als Vergleichswert) |
|---|---|---|---|---|---|
| D | 2,5 % | 0,775 | 0,006 | +7 | +4 |
| F | 5 % | 0,775 | 0,007 | +7 | +4 |
| H | 10 % | 0,757 | 0,004 | -11 | +18 |
| I | 10 % | 0,775 | 0,003 | -7 | +8 |
| J | 10 % | 0,768 | 0,008 | -6 | 0 |
| L | 20 % | 0,777 | 0,009 | +2 | 0 |
| M | 20 % | 0,773 | 0,007 | +5 | +9 |

(1) Die typischen Lichtempfindlichkeiten des Standards 2,3,4,-Trihydroxybenzophenon-1,2-naphthochinondiazid-4-sulfonsäuretriester betragen bei einer Breitbandbelichtung (350–450 nm), gemessen bei 405 nm, 18,9 mJ/cm² und bei einer Schmalbandbelichtung (365 nm), gemessen bei 365 nm, 20,6 mJ/cm².

(2) Die typischen Bildkontrastwerte des Standards 2,3,4-Trihydroxybenzophenon-1,2,-naphthochinondiazid-4-sulfonsäuretriester betragen für eine Breitbandbelichtung (350–450 nm), gemessen bei 405 nm, 3,09 und bei einer Schmalbandbelichtung (365 nm), gemessen bei 365 nm, 2,43.

## Patentansprüche

1. Lichtempfindliches Gemisch, enthaltend ein in wäßrigen Systemen unlösliches, in wäßrig alkalischen und organischen Lösemitteln lösliches, zumindest aber quellbares Bindemittel sowie eine lichtempfindliche Verbindung, dadurch gekennzeichnet, daß die lichtempfindliche Verbindung ein Kondensationsprodukt ist aus einer Phenolverbindung der Formel I

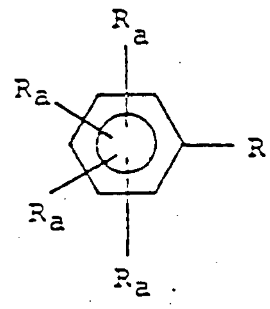

(I)

in der

R Wasserstoff, $-X-R_b$ oder

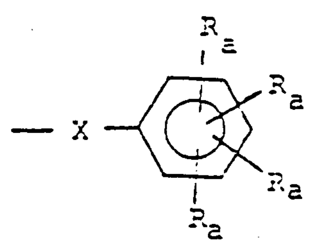

darstellt,

$R_a$ Wasserstoff, eine OH-Gruppe, Halogen oder eine niedere Alkylgruppe darstellt, wobei mindestens zwei und höchstens sechs $R_a$-Gruppen OH-Gruppen sind,

X eine C-C-Bindung, -O-, -S- $-SO_2-$,

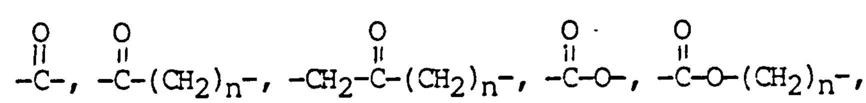

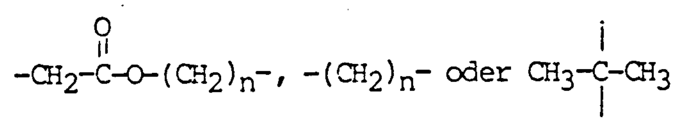

darstellt,

n 1 oder 2 bedeutet und

$R_b$ Wasserstoff oder eine gegebenenfalls substituierte Alkyl- oder Arylgruppe bedeutet;

oder der Formel II

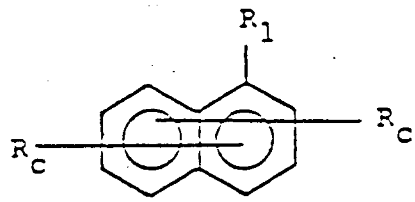

(II)

in der

$R_1$ Wasserstoff oder

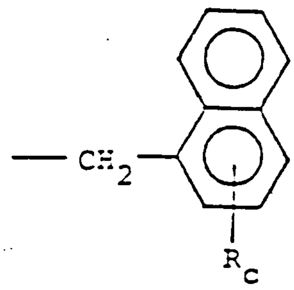

bedeutet und

$R_c$ Wasserstoff, oder eine OH-Gruppe bedeutet, wobei mindestens zwei $R_c$-Gruppen OH-Gruppen sind;

oder der Formel III

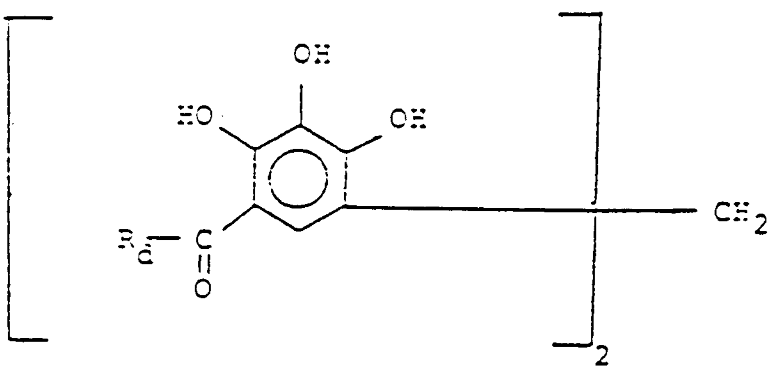

III

in der

$R_d$ Wasserstoff oder eine gegebenenfalls substituierte Alkyl- oder Arylgruppe bedeutet;

mit einer Mischung aus einem 1,2-Naphthochinondiazid-4-sulfonsäurechlorid (Diazoverbindung 1) und einem 1,2-Naphthochinondiazid-5-sulfonsäurechlorid (Diazoverbindung 2) in einem Molverhältnis zwischen 1,5:1 und 39:1.

**2.** Lichtempfindliches Gemisch nach Anspruch 1, dadurch gekennzeichnet, daß in der Phenolverbindung der Formel I

R -X-$R_b$,

$R_a$ Wasserstoff und OH-Gruppen,

X

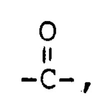

$R_b$ Aryl, insbesondere Phenyl,

in der Phenolverbindung der Formel II

$R_1$ Wasserstoff,

$R_c$ OH-Gruppen,

und in der Phenolverbindung der Formel III

$R_d$ Phenyl oder Alkyl mit 1 bis 20 C-Atomen

bedeutet.

**3.** Lichtempfindliches Gemisch Anspruch 1 oder 2, dadurch gekennzeichnet, daß das Bindemittel ein Novolak oder ein Polyvinylphenol ist.

4. Lichtempfindliches Gemisch nach einem oder mehreren der Ansprüche 1 bis 3, dadurch gekennzeichnet, daß das Gemisch ein Lösemittel bzw. ein Lösemittelgemisch enthält.

5. Lichtempfindliches Gemisch nach einem oder mehreren der Ansprüche 1 bis 4, dadurch gekennzeichnet, daß das Gemisch zusätzlich Farbstoffe, Verlaufmittel, Weichmacher, Haftvermittler, Entwicklungsbeschleuniger und/oder nichtionische Tenside enthält.

6. Lichtempfindliches Gemisch nach einem oder mehreren der Ansprüche 1 bis 5, dadurch gekennzeichnet, daß das Bindemittel in einer Konzentration von 15 bis 99 Gew.-%, bezogen auf die festen Bestandteile des lichtempfindlichen Gemisches, vorliegt.

7. Lichtempfindliches Gemisch nach einem oder mehreren der Ansprüche 1 bis 6, dadurch gekennzeichnet, daß die lichtempfindliche Verbindung in einer Konzentration von 1 bis 85 Gew.-%, bezogen auf die festen Bestandteile des lichtempfindlichen Gemisches, vorliegt.

8. Aufzeichnungsmaterial, im wesentlichen bestehend aus einem Träger und einer lichtempfindlichen Schicht, dadurch gekennzeichnet, daß die lichtempfindliche Schicht dem lichtempfindlichen Gemisch nach einem oder mehreren der Ansprüche 1 bis 7 entspricht.

9. Aufzeichnungsmaterial nach Anspruch 8, dadurch gekennzeichnet, daß der Träger ein mit einer thermisch gezüchteten Siliciumdioxidschicht beschichteter Siliciumwafer ist.

10. Verfahren zur Herstellung einer Photoresistschablone mittels eines Aufzeichnungsmaterials nach den Ansprüchen 8 oder 9, dadurch gekennzeichnet, daß das lichtempfindliche Gemisch auf den Träger aufgebracht wird, das Aufzeichnungsmaterial einer Vortrocknung bei 80 bis 105 °C unterworfen wird, bildmäßig belichtet und anschließend entwickelt und sowie ggf. einer Wärmebehandlung unterworfen wird.

**Claims**

1. Photosensitive composition which contains a binder which is insoluble in aqueous systems but is soluble, or at least swellable, in aqueous alkaline or organic solvents, and also a photosensitive compound, characterised in that the photosensitive compound is a product of condensing a phenolic compound of the formula I

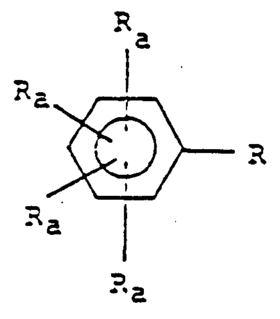

(I)

in which

R is hydrogen, -X-$R_b$ or

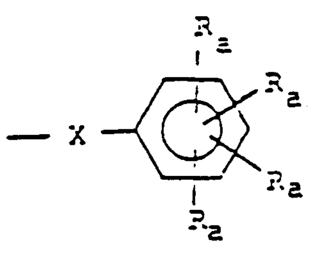

$R_a$ is hydrogen, an OH group, halogen or a lower alkyl group, not less than two and not more than six $R_a$ groups being OH groups,

X is a C-C bond, -O-, -S- $-SO_2-$,

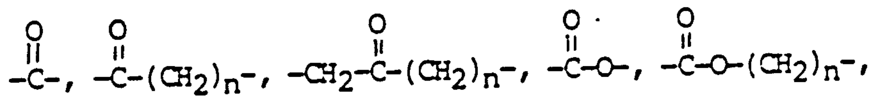

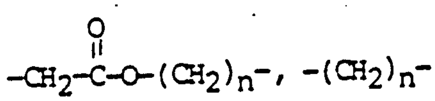

or

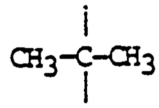

n is 1 or 2, and

$R_b$ is hydrogen or an optionally substituted alkyl or aryl group;

or of the formula II

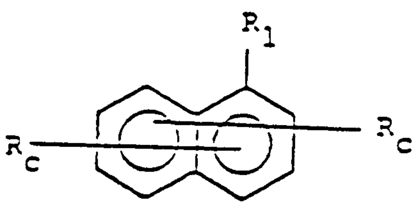

(II)

in which

$R_1$ is hydrogen or

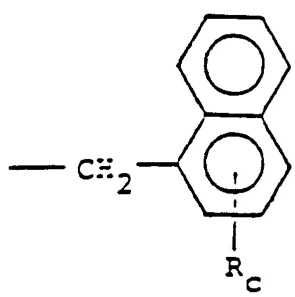

and

$R_c$ is hydrogen or an OH group, not less than two $R_c$ groups being OH groups;

or of the formula III

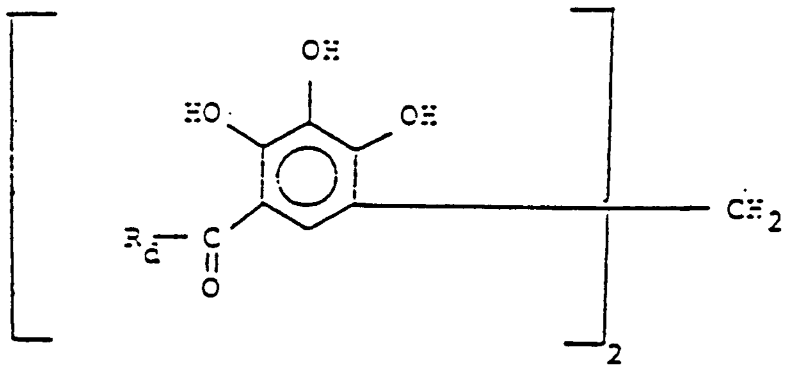

III

in which

$R_d$ is hydrogen or an optionally substituted alkyl or aryl group;

with a mixture composed of a 1,2-naphthoquinonediazide-4-sulphonyl chloride (diazo compound 1) and a 1,2-naphthoquinonediazide-5-sulphonyl chloride (diazo compound 2) in a molar ratio of between 1.5:1 and 39:1.

**2.** Photosensitive composition according to Claim 1, characterised in that, in the phenolic compound of the formula I,

R is $-X-R_b$,

$R_a$ is hydrogen and OH groups,

x is

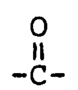

,

$R_b$ is aryl, in particular phenyl,

in the phenolic compound of the formula II

$R_1$ is hydrogen,

$R_c$ is OH groups,

and in the phenolic compound of the formula III

$R_d$ is phenyl or alkyl having 1 to 20 carbon atoms.

**3.** Photosensitive composition according to claim 1 or 2, characterised in that the binder is a novolak or a polyvinylphenol.

**4.** Photosensitive composition according to one or more of Claims 1 to 3, characterised in that the composition contains a solvent or a solvent mixture.

**5.** Photosensitive composition according to one or more of Claims 1 to 4, characterised in that the composition additionally contains dyes, flow-control agents, plasticisers, adhesion promoters, development accelerators and/or nonionic surfactants.

**6.** Photosensitive composition according to one or more of Claims 1 to 5, characterised in that the binder is present in a concentration of 15 to 99 % by weight, based on the solid constituents of the photosensitive composition.

**7.** Photosensitive composition according to one or more of Claims 1 to 6, characterised in that the photosensitive compound is present in a concentration of 1 to 85 % by weight, based on the solid constituents of the photosensitive composition.

**8.** Recording material essentially comprising a base and a photosensitive layer, characterised in that the photosensitive layer corresponds to the photosensitive composition according to one or more of Claims

1 to 7.

9. Recording material according to Claim 8, characterised in that the base is a silicon wafer coated with a thermally grown silicon dioxide layer.

10. Process for preparing a photoresist template by means of a recording material according to Claims 8 or 9, characterised in that the photosensitive composition is applied to the base, the recording material is subjected to a preliminary drying at 80 to 105 °C, imagewise exposed and then developed and is optionally subjected to a thermal treatment.

**Revendications**

1. Composition photosensible contenant un liant insoluble dans des systèmes aqueux, soluble ou au moins susceptible de gonfler dans des solvants organiques et aqueux-alcalins, ainsi qu'un composé photosensible, caractérisée en ce que le composé photosensible est un produit de condensation obtenu à partir d'un composé phénolique de formule I

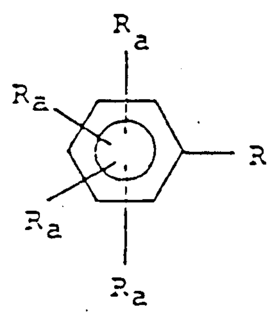

(I)

dans laquelle

R représente un atome d'hydrogène, $-X-R_b$ ou

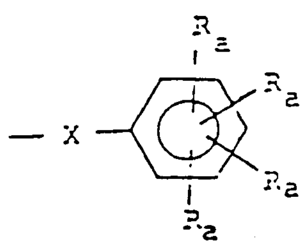

$R_a$ représente un atome d'hydrogène, un groupe OH, un atome d'halogène ou un groupe alkyle inférieur, au moins 2 et au maximum 6 groupes $R_a$ étant des groupes OH,

X représente une liaison C-C, -O-, -S-, $-SO_2-$,

$$-\overset{O}{\overset{\|}{C}}-,$$

$$-\overset{O}{\overset{\|}{C}}-(CH_2)_n-,\quad -CH_2-\overset{O}{\overset{\|}{C}}-(CH_2)_n-,\quad -\overset{O}{\overset{\|}{C}}-O-,\quad -\overset{O}{\overset{\|}{C}}-O-(CH_2)_n-,$$

$$-CH_2-\overset{O}{\overset{\|}{C}}-O-(CH_2)_n-,\quad -(CH_2)_n-\ \text{ou}\ CH_3-\underset{|}{\overset{|}{C}}-CH_3,$$

n est 1 ou 2, et

$R_b$ représente un atome d'hydrogène ou un groupe alkyle ou aryle éventuellement substitué;
ou de formule II

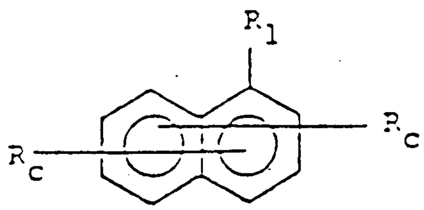

(II)

dans laquelle
$R_1$ représente un atome d'hydrogène ou

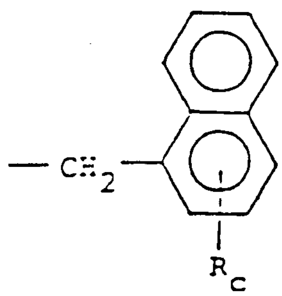

et
$R_c$ représente un atome d'hydrogène ou un groupe OH, au moins 2 groupes $R_c$ étant des groupes OH;
ou de formule III

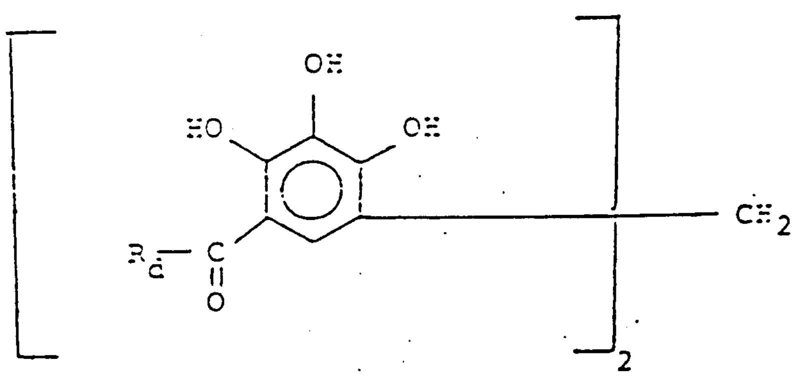

(III)

dans laquelle
$R_d$ représente un atome d'hydrogène ou un groupe alkyle ou aryle éventuellement substitué;
avec un mélange d'un chlorure de 1,2-naphtoquinonediazido-4-sulfonyle (composé diazoïque 1) et d'un chlorure de 1,2-naphtoquinonediazido-5-sulfonyle (composé diazoïque 2), en un rapport molaire compris entre 1,5:1 et 39:1.

**2.** Composition photosensible selon la revendication 1, caractérisée en ce que, dans le composé phénolique de formule I,
R représente $-X-R_b$,
$R_a$ représente des atomes d'hydrogène et des groupes OH,
x représente

$$-\overset{\displaystyle O}{\overset{\|}{C}}-,$$

$R_b$ représente un groupe aryle, en particulier phényle, dans le composé phénolique de formule II,

$R_1$ représente un atome d'hydrogène,

$R_c$ représente des groupes OH,

et dans le composé phénolique de formule III,

$R_d$ représente le groupe phényle ou un groupe alkyle ayant de 1 à 20 atomes de carbone.

**3.** Composition photosensible selon la revendication 1 ou 2, caractérisée en ce que le liant est une Novolaque ou un polyvinylphénol.

**4.** Composition photosensible selon une ou plusieurs des revendications 1 à 3, caractérisée en ce que la composition contient un solvant ou un mélange de solvants.

**5.** Composition photosensible selon une ou plusieurs des revendications 1 à 4, caractérisée en ce que la composition contient en outre des colorants, agents d'étalement, plastifiants, agents favorisant l'adhérence, accélérateurs de développement et/ou des surfactifs non ioniques.

**6.** Composition photosensible selon une ou plusieurs des revendications 1 à 5, caractérisée en ce que le liant est présent à une concentration de 15 à 99 % en poids, par rapport aux composants solides de la composition photosensible.

**7.** Composition photosensible selon une ou plusieurs des revendications 1 à 6, caractérisée en ce que le composé photosensible est présent à une concentration de 1 à 85 % en poids, par rapport aux composants solides de la compositions photosensible.

**8.** Matériau de reprographie, essentiellement constitué d'un support et d'une couche photosensible, caractérisé en ce que la couche photosensible correspond à la composition photosensible selon une ou plusieurs des revendications 1 à 7.

**9.** Matériau de reprographie selon la revendication 8, caractérisé en ce que le support est une plaquette de silicium revêtue d'une couche de dioxyde de silicium produite thermiquement.

**10.** Procédé pour la fabrication d'un masque de photorésist, au moyen d'un matériau de reprographie selon la revendication 8 ou 9, caractérisé en ce que la composition photosensible est appliquée sur le support, le matériau de reprographie est soumis à un préséchage à 80-105 °C, insolé selon l'image et ensuite développé, ainsi qu'éventuellement soumis à un traitement thermique.